# EUROPÄISCHE PATENTSCHRIFT

(11) **EP 3 474 645 B1**
(45) Veröffentlichungstag und Bekanntmachung des Hinweises auf die Patenterteilung: **22.12.2021**
(21) Anmeldenummer: 18200775.7
(22) Anmeldetag: 16.10.2018
(51) Int. Cl.: H05K 5/00, H05K 5/06, G01D 11/24

(54) **VERFAHREN ZUR HERSTELLUNG EINER ELEKTRONISCHEN KOMPONENTE, INSBESONDERE EINER MECHATRONIKKOMPONENTE**
METHOD FOR MAKING AN ELECTRONIC COMPONENT, IN PARTICULAR A MECHATRONIC COMPONENT
PROCÉDÉ DE FABRICATION D'UN COMPOSANT ÉLECTRONIQUE, EN PARTICULIER D'UN COMPOSANT MÉCATRONIQUE

(30) Priorität: 19.10.2017 DE 102017218659
(43) Veröffentlichungstag der Anmeldung: 24.04.2019
(73) Patentinhaber: AUDI AG, 85045 Ingolstadt (DE)
(72) Erfinder: Aigner, Konrad, 93333 Neustadt-Hienheim (DE); Traxler, Franz, 85049 Ingolstadt (DE)

(56) Entgegenhaltungen:
- EP-A1- 1 690 269
- DE-A1- 10 021 672
- DE-A1- 10 207 762

## Beschreibung

Die Erfindung betrifft ein Verfahren zur Herstellung einer elektronischen Komponente, insbesondere einer Mechatronikkomponente, umfassend wenigstens ein elektronisches Bauteil, das in ein Gehäuse eingebracht wird, wobei zwischen dem Bauteil und dem Gehäuse ein oder mehrere, die Größe von weniger als 1 mm aufweisende Mikrospalte verbleiben.

In unterschiedlichsten Anwendungsfällen kommen elektronische Komponenten zum Einsatz, die ein oder mehrere elektronische Bauteile umfassen, welche in ein Gehäuse eingebracht sind. Zu nennen ist lediglich exemplarisch als elektronisches Bauteil ein auf einer Platine aufgebauter Sensor, der eingehaust ist. Ein solcher Sensor kann beispielsweise als Mechatronikkomponente Teil eines umfassenderen mechatronischen Systems, beispielsweise eines Fahrerassistenzsystems oder dergleichen sein, aber auch als Füllstandsensor verwendet werden oder dergleichen.

Das Einhausen eines solchen Bauteils, insbesondere eines sensitiven Bauteils wie eines Sensors, in ein Gehäuse ist üblich und oft unumgänglich. Dabei kann entweder das Bauteil in ein vorgefertigtes Gehäuse eingesetzt werden, wobei, um die Komponente möglichst kleinbauend zu halten, das Gehäuse möglichst exakt auf die Geometrie des aufzunehmenden Bauteils abgestimmt ist. Eine Platine nebst Sensor kann beispielsweise in ein entsprechendes, sehr schmales Gehäuse, das auch aus einem elastischen Material sein kann, so dass es sich möglichst eng an das Bauteil anlegen kann, eingeschoben werden. Daneben ist es bekannt, das Bauteil mit einem Kunststoffmaterial, das das Gehäuse bildet, zu umspritzen, das heißt, dass das Bauteil quasi in das Gehäuse eingebettet wird. Auch hier kann eine auf die tatsächliche Bauteilgeometrie abgestimmte Gehäusegeometrie erreicht werden.

Unabhängig davon, wie nun das Bauteil in das Gehäuse eingebracht wird, bleiben jedoch stets kleine Spalte, im vorliegenden "Mikrospalte" genannt, zwischen dem Bauteil und dem Gehäuse. Bei einem vorgefertigten Gehäuse, insbesondere wenn dieses nicht elastisch ist und sich an das Bauteil anlegt, liegt dies auf der Hand. Auch bei einem elastischen, vorgefertigten Gehäuse können Mikrospalte, die eine Größenordnung von wenigen Mikrometern oder zehntel Millimetern aufweisen, und die gegebenenfalls auch durch eine thermische Zyklisierung der beteiligten Komponenten ihre Größe variieren können, zwischen Bauteil und Gehäuse gegeben sein. Ebenso bei einem Umspritzen des Bauteils mit einem Kunststoff, beispielsweise HDPE, entstehen derartige Mikrospalte. Denn nicht immer sind die Oberflächen der beteiligten Elemente, also Bauteil einerseits und Kunststoffmatrix andererseits, hinreichend adhäsiv respektive benetzen einander in ausreichendem Maß, so dass infolge der fehlenden Benetzung keine quasi stoffflüssige Verbindung oder haftende Verbindung entsteht. In die verbleibenden Mikrospalte kann beispielsweise aufgrund eindringender Wassermoleküle Feuchtigkeit eindringen, so dass sich in den Mikrospalten ein Mikroklima bildet, das eine Störung der Funktion des elektronischen Bauteils hervorrufen kann. Handelt es sich bei dem Bauteil beispielsweise um einen Sensor, beispielsweise einen kapazitiven, berührungslos arbeitenden Sensor, so kann dieser sehr sensibel auf eindringendes Wasser oder wasserhaltige Substanzen reagieren. Beispielsweise kann der Sensor durch das feuchte Mikroklima permanent aktiviert werden und seine Sensitivität verlieren, da er permanent anspricht.

Aus DE 100 21 672 A1 ist ein Sensor mit einem Gehäuse bekannt, in dem eine Duroplast-Formmasse angeordnet ist, in der elektrisch aktive Bauteile einer Leiterplatte eingebettet sind. Die Duroplast-Formmasse weist an der Außenseite eine sägezahnartige Geometrie mit Ringnuten auf. Sie ist mit einer Thermoplast-Formmasse umspritzt, die den Spalt zwischen der Duroplast-Formmasse und dem Gehäuse füllt und die form- und kraftschlüssig in die Ringnuten eingreift. Da sich beide Formmassen nicht benetzen, kommt es zu keinem Stoffschluss, so dass sich Spalte zwischen den Formmassen bilden. Im Fall einer thermisch bedingten Längenänderung laufen die Flanken der Ringnut-Abschnitte der Formmassen gegeneinander und dichten ab.

In EP 1 690 269 B1 ist ein abgedichtetes elektrotechnisches Gerät mit zwei Dichtungen und ein Verfahren zu seiner Herstellung beschrieben. Dieses Gerät umfasst einen Container, in den die elektrischen Bauteile, beispielsweise Kondensatoren, aufgenommen sind. Der Container weist einen oberen Flansch auf, auf den ein Deckel aufgesetzt wird. Im Deckel ist eine erste Nut vorgesehen, in die ein Dichtring als erste Dichtebene eingesetzt wird, der zum Container hin abdichtet. An dem Deckel ist des Weiteren in einer Nut ein weiteres Dichtelement angeordnet, das im aufgesetzten Zustand des Deckels an dem Flansch aufliegt und eine deckelseitig ausgebildete Ringnut radial begrenzt. Nach Aufsetzen des Deckels, der mit entsprechenden Schrauben festgeschraubt wird, wird ein Dichtmittel, bei dem es sich um eine Silikonpaste handeln kann, über einen Zuführkanal in die Ringnut eingedrückt, so dass hierüber eine weitere Dichtebene ausgebildet wird.

In DE 102 07 762 A1 ist ein elektrotechnisches Gerät beschrieben, bei dem in ein Gehäuse eine erste Komponente umfassend Leiterplatten sowie eine zweite Komponente in Form einer Sensorbaugruppe eingesetzt werden. An der ersten Komponente sind Kontaktstifte vorgesehen, die beim Einsetzen der ersten Komponente eine Rückwand eines Einsatzes durchstechen und in eine Kammer hineinragen, die an diesem Einsatz ausgebildet ist, wo sodann eine Kontaktierung zur zweiten Komponente erfolgt. Sodann wird die Kammer mit einem Vergussmaterial vergossen.

Der Erfindung liegt damit das Problem zugrunde, ein Verfahren anzugeben, das eine verbesserte Kapselung eines elektronischen Bauteils ermöglicht.

Zur Lösung dieses Problems ist erfindungsgemäß ein Verfahren zur Herstellung einer elektronischen Komponente, insbesondere einer Mechatronikkomponente, umfassend wenigstens ein elektronisches Bauteil, das in ein Gehäuse eingebracht wird, vorgesehen, wobei zwischen dem Bauteil und dem Gehäuse ein oder mehrere, die Größe von weniger als 1 mm aufweisende Mikrospalte verbleiben, wobei die Mikrospalte mit einem fluiden, nicht aushärtenden oder im ausgehärteten Zustand elastischen Füllmittel verfüllt werden, das über eine gehäuseseitige erste Öffnung mittels eines an eine gehäuseseitige zweite Öffnung angelegten Unterdrucks bis zur vollständigen Verfüllung des oder der Mikrospalte eingesaugt wird, oder das mittels Überdruck an der ersten Öffnung bis zur vollständigen Verfüllung des oder der Mikrospalte eingedrückt wird.

Erfindungsgemäß ist vorgesehen, in das Gehäuse zur Verfüllung der Mikrospalte, die wie beschrieben Größen im Bereich weniger Mikrometer oder zehntel Millimeter besitzen, ein entsprechendes Füllmittel einzubringen, das entweder nicht aushärtet oder im ausgehärteten Zustand elastisch ist. Dieses im Einbringzustand in jedem Fall flüssige Füllmittel ist in der Lage, sich in dem oder den Mikrospalten entsprechend zu verteilen und diese vollständig zu verfüllen, nachdem es mittels Unterdrucks aktiv eingesaugt wird, mithin also auch durch respektive in die Mikrospalte gesaugt wird, oder mit Überdruck aktiv eingepresst wird. Hierzu sind zwei Öffnungen am Gehäuse vorgesehen, nämlich eine erste Ansaugöffnung sowie eine zweite Öffnung, an der der entsprechende saugende Unterdruck angelegt wird. Im Falle eines Einpressens mit Überdruck wird dieser an die erste Öffnung angelegt.

Aufgrund des Umstands, dass einerseits auf diese Weise die Mikrospalte vollständig verfüllt werden, andererseits aber das Füllmittel entweder nicht aushärtet oder im ausgehärteten Zustand elastisch ist, bleiben auch bei Einsatz der elektronischen Komponente die Mikrospalte geschlossen und verfüllt, da etwaige, wenngleich minimale Relativbewegungen von Bauteil und Gehäuse zueinander am Verfüllzustand nichts ändern. Dies führt wiederum dazu, dass das eingebrachte Bauteil, beispielsweise der Sensor, vollständig und in jeder Situation gekapselt und damit geschützt ist, so dass die eingangs genannten Probleme nicht auftreten.

Als Füllmittel wird ein solches gewählt, das hinreichend dünnflüssig respektive niederviskos ist, so dass es einerseits gut eingesogen oder eingedrückt werden kann, sich andererseits aber auch sehr gut in dem oder den Mikrospalten verteilt. Bevorzugt wird ein Füllmittel verwendet, das im Hinblick auf die beteiligten Materialien seitens des Bauteils sowie des Gehäuse gute benetzende Eigenschaften aufweist, wobei dies jedoch nicht zwingend ist.

Im Rahmen des erfindungsgemäßen Verfahrens kann das Bauteil zur Ausbildung des Gehäuses mit einem Kunststoff umspritzt werden. Im Rahmen dieses Umspritzens können sogleich die beiden Öffnungen mit ausgebildet werden. Im Anschluss, wenn das Kunststoffgehäuse ausgehärtet ist, kann die Verfüllung erfolgen. Alternativ kann das Bauteil auch in ein vorgefertigtes Gehäuse eingesetzt werden, wobei auch in diesem vorgefertigten Gehäuse die beiden Öffnungen bereits vorkonfiguriert sein können. Selbstverständlich werden die Öffnungen nach dem Verfüllen mit dem Füllmittel, z.B. mit einem Stöpsel, vollständig verschlossen, so dass das Gehäuse das Bauteil komplett kapselt.

Als Füllmittel wird besonders bevorzugt ein solches verwendet, das undurchlässig für Wassermoleküle ist, so dass ausgeschlossen ist, dass Wasser eindringen kann, selbst wenn dieses aus welchem Grund auch immer, durch das Gehäuse diffundieren kann. Spätestens über die Füllmittelebene wird ein weiteres Eindringen der Wassermoleküle verhindert. Das Füllmittel selbst sollte ebenfalls keine Feuchtigkeit aufnehmen.

Ein geeignetes Füllmittel ist bevorzugt ein sehr dünnflüssiges Silikon, insbesondere ein Silikonelastomer oder ein Silikonharz, die beide aushärten, jedoch nach wie vor elastisch bleiben, oder ein Silikonöl, das permanent flüssig ist. Silikone respektive die genannten spezifischen Silikone haben den Vorteil, dass sie sich gut an die sich der Adhäsion widersetzenden Elemente, also das Bauteil und das Gehäuse, anschmiegen respektive der entsprechenden Spaltform folgen und auch bei thermischer bedingter Veränderung der Spaltbreite nachgeben, den Spalt jedoch permanent ausfüllen. Natürlich sind auch andere Füllmittel als Silikone verwendbar, wenn sie entsprechende Parameter hinsichtlich Elastizität respektive permanenter Fluidität sowie der Undurchlässigkeit für Wasser aufweisen und hinreichend dünnflüssig für die Einbringung sind.

Es besteht die Möglichkeit, das Gehäuse vor dem Befüllen zu evakuieren, um etwaige Lufteinschlüsse im Gehäuse zu entfernen. Nach dem evakuieren kann sodann die Befüllung erfolgen. Alternativ ist es denkbar, den Befüllvorgang bei Atmosphärendruck durchzuführen. Insbesondere, jedoch nicht ausschließlich, in diesem Fall ist es dann zweckmäßig, das Gehäuse während des Befüllvorgangs vollständig mit Füllmittel zu durchspülen, mithin also das Füllmittel in etwas größerer Menge durch das Gehäuse hindurch zu fördern, um entsprechende Lufteinschlüsse oder Luftblasen auszutreiben.

Wie bereits beschrieben, werden nach dem Befüllen die beiden Öffnungen verschlossen, was entweder durch Anspritzen eines entsprechenden Kunststoffverschlusses erfolgen kann, oder durch Aufsetzen einer geeigneten, abgedichteten Verschlusskappe oder Ähnliches.

Das Bauteil selbst kann ein beliebiges Bauteil sein, bevorzugt handelt es sich dabei jedoch um eine Platine, mit wenigstens einem auf ihr aufgebauten Sensor, insbesondere einem kapazitiven Sensor.

Neben dem Verfahren selbst betrifft die Erfindung ferner eine elektronische Komponente, insbesondere eine Mechatronikkomponente, die gemäß dem vorstehend beschriebenen Verfahren hergestellt ist.

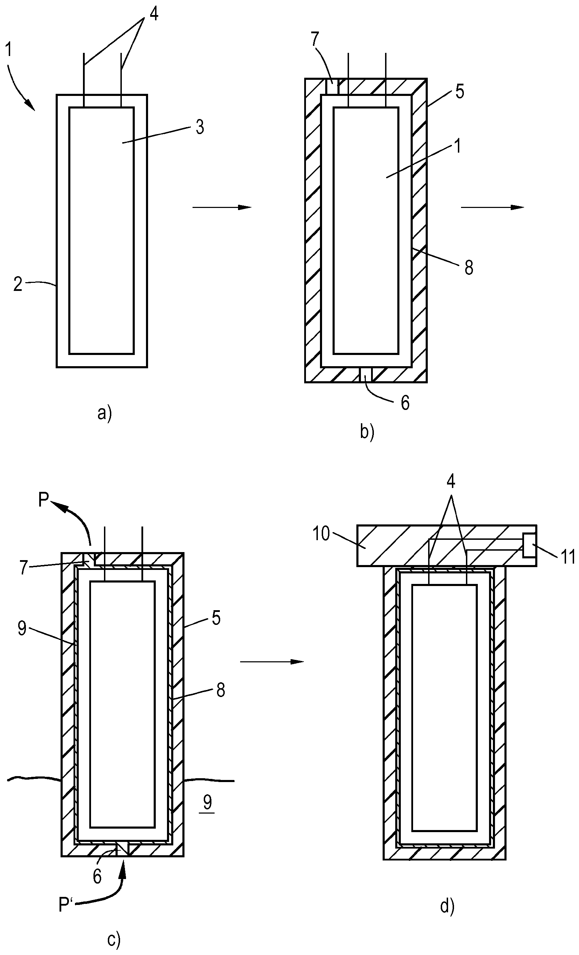

In der einzigen Figur ist ein Ablaufdiagramm zur Erläuterung des erfindungsgemäßen Verfahrens gezeigt.

Im Figurenteil a) ist in einer Prinzipdarstellung ein elektronisches Bauteil 1 gezeigt, umfassend eine Platine 2, auf der ein Sensor 3, beispielsweise ein kapazitiver Sensor, aufgebaut ist. Der Sensor 3 ist über zwei Anschlussleitungen 4 mit einer nachgeschalteten Elektronik verbindbar.

Das Bauteil 1 wird im nächsten Schritt, siehe Figurenteil b), in ein Gehäuse 5 eingebracht. Dieses Gehäuse 5 wird bevorzugt in einem Spritzverfahren aus Kunststoff um das Bauteil 1 herumgespritzt, so dass dieses nahezu vollständig in die Kunststoffmasse eingebettet ist. Das Gehäuse 5 weist lediglich eine erste Öffnung 6 an der Unterseite sowie an der gegenüberliegenden Seite eine zweite Öffnung 7 auf, durch die nachfolgend ein fluides Füllmittel durch das Gehäuse gesaugt wird. Die Öffnungen 6, 7 müssen jedoch nicht einander gegenüber liegen, z.B. kann eine Öffnung auch seitlich angeordnet sein.

Ersichtlich kapselt das Gehäuse 5 das Bauteil 1 bis auf die Öffnungen vollständig ein. Aufgrund möglicherweise nicht optimaler Benetzung zwischen dem Gehäusematerial und dem Bauteil 1 verbleiben im Bereich aneinander liegenden Grenzflächen von Gehäuse 5 und Bauteil 1 ein oder mehrere Mikrospalte 8 zwischen Bauteil 1 und Gehäuse 5, in die gegebenenfalls Feuchtigkeit oder ähnliches eindringen kann, was zur Beeinträchtigung der Sensorfunktionalität führen kann. Der Mikrospalt kann auch das gesamte Bauteil 1 umgeben, wenn allseitig keine adhäsive Benetzung stattfindet.

Aus diesem Grund wird im nächsten Schritt, siehe Teilfigur c), die gesamte Komponente in ein flüssiges Füllmittel 9 getaucht und im gezeigtem Beispiel mit einer geeigneten Unterdruckerzeugungseinrichtung, wie durch den Pfeil P dargestellt, ein Unterdruck an die zweite Öffnung 7 gelegt. Dieser Unterdruck führt dazu, dass, wie durch den Pfeil P' dargestellt ist, das Füllmittel durch die erste Öffnung 6 in das Gehäuse 5 eingesaugt wird und sich in dem oder den Mikrospalten 8 verteilt, diese also vollständig ausfüllt. Es bildet sich beispielsweise im Fall eines das Bauteil vollständig umgebenden Mikrospalts um das Bauteil 1 herum eine Zwischenschicht aus dem Füllmittel, das bevorzugt durch das Gehäuse in entsprechend größerer Menge gesaugt wird, um auch etwaige Lufteinschlüsse oder dergleichen austreiben zu können, sofern der Verfüllvorgang nicht unter Vakuum erfolgt. Das Bauteil 1 ist über die es komplett umgebende Füllmittelschicht vollständig gekapselt.

Das verwendete Füllmittel ist zumindest während des Befüllvorgangs flüssig. Bevorzugt handelt es sich um ein Öl oder ein Silikon, insbesondere ein Silikonelastomer oder ein Silikonharz. Diese Silikontypen härten leicht aus, bleiben aber nach wie vor hinreichend elastisch, um auch etwaige Relativbewegungen von Bauteil 1 und Gehäuse 5 zueinander, die gegebenenfalls spaltvergrößernd sein können, auszugleichen, mithin also den Spalt permanent zu verschließen. Alternativ kann auch ein Silikonöl verwendet werden, das permanent flüssig bleibt und das gleichermaßen zu jedem Zeitpunkt den oder die Mikrospalte 8 vollständig ausfüllt.

Das verwendete Füllmittel sollte zweckmäßigerweise für Wassermoleküle undurchlässig sein, so dass über das Füllmittel 9 eine entsprechende Barrierenschicht um das Bauteil 1 erzeugt wird, die einen Durchtritt von Wasser vollständig verhindert.

Nach Einbringen des Füllmittels 9 durch Einsaugen wird sodann im letzten Schritt, siehe Figurenteil d, einerseits die untere Öffnung 6 verschlossen, indem dort beispielsweise erneut etwas Kunststoffmaterial angespritzt wird. Ebenso wird die obere Öffnung 7 verschlossen, wobei im gezeigten Beispiel eine Kappe 10 aufgesetzt wird, die den oberseitigen dichten Verschluss liefert und gleichzeitig aber auch die Anschlussleitungen 4 mit einem entsprechenden Kontaktstecker 11 verbindet, in dem sodann die entsprechenden Sensorsignale abgegriffen werden können.

Abschließend ist festzuhalten, dass es sich bei dem beschriebenen Ausführungsbeispiel lediglich um einen Beispielfall handelt und die Figuren reine Prinzipdarstellungen sind. Selbstverständlich können auch anders gestaltete Bauteile oder anders aufgebaute Bauteile entsprechend verwendet werden, wie auch das Gehäuse 5 vorgefertigt sein kann, also nicht erst umspritzt wird. Das Funktionsprinzip ist jedoch das gleiche, nachdem stets entsprechende Mikrospalte verbleiben können, die mit dem Füllmittel in der erfindungsgemäße Weise ausgefüllt werden. Auch kann anstelle des Einsaugens per Unterdruck das Füllmittel über die erste Öffnung 6 per Überdruck eingepresst werden, bis der oder die Mikrospalte 8 verfüllt sind.

## Patentansprüche

1. Verfahren zur Herstellung einer elektronischen Komponente, insbesondere einer Mechatronikkomponente, umfassend wenigstens ein elektronisches Bauteil (1), das in ein Gehäuse (5) eingebracht wird, wobei zwischen dem Bauteil (1) und dem Gehäuse (5) ein oder mehrere, die Größe von weniger als 1 mm aufweisende Mikrospalte (8) verbleiben,
wobei die Mikrospalte (8) mit einem fluiden, nicht aushärtenden oder im ausgehärteten Zustand elastischen Füllmittel (9) verfüllt werden, das über eine gehäuseseitige erste Öffnung (6) mittels eines an eine gehäuseseitige zweite Öffnung (7) angelegten Unterdrucks bis zur vollständigen Verfüllung des oder der Mikrospalte (8) eingesaugt wird, oder das mittels Überdruck an der ersten Öffnung (6) bis zur vollständigen Verfüllung des oder der Mikrospalte (8) eingedrückt wird.

2. Verfahren nach Anspruch 1,
**dadurch gekennzeichnet,**
**dass** das Bauteil (1) zur Ausbildung des Gehäuses (5) mit einem Kunststoff umspritzt wird, oder das das Bauteil (1) in ein vorgefertigtes Gehäuse (5) eingesetzt wird.

3. Verfahren nach Anspruch 1 oder 2,
**dadurch gekennzeichnet,**
**dass** als Füllmittel (9) ein für Wassermoleküle undurchlässiger Füllstoff verwendet wird.

4. Verfahren nach Anspruch 3,
**dadurch gekennzeichnet,**
**dass** als Füllmittel (9) ein Silikon, insbesondere ein Silikonelastomer, ein Silikonharz oder ein Silikonöl verwendet wird.

5. Verfahren nach einem der vorangehenden Ansprüche,
**dadurch gekennzeichnet,**
**dass** vor dem Befüllen das Gehäuse (5) evakuiert wird, oder dass der Befüllvorgang bei Atmosphärendruck erfolgt.

6. Verfahren nach einem der vorangehenden Ansprüche,
**dadurch gekennzeichnet,**
**dass** das Gehäuse (5) während des Befüllvorgangs vollständig mit dem Füllmittel (9) durchspült wird.

7. Verfahren nach einem der vorangehenden Ansprüche,
**dadurch gekennzeichnet,**
**dass** nach dem Befüllen beide Öffnungen (6, 7) verschlossen werden.

8. Verfahren nach einem der vorangehenden Ansprüche,
**dadurch gekennzeichnet,**
**dass** das Bauteil (1) eine Platine (2) mit wenigstens einem auf ihr aufgebauten Sensor (3), insbesondere einem kapazitiven Sensor (3) ist.

9. Elektronische Komponente, insbesondere Mechatronikkomponente, hergestellt nach dem Verfahren nach einem der vorangehenden Ansprüche.

## Claims

1. Method for producing an electronic component, in particular a mechatronics component, comprising at least one electronic component (1), which is introduced into a housing (5), wherein one or more microgaps (8) with a size of less than 1 mm remain between the component (1) and the housing (5),
wherein the microgaps (8) are filled with a fluid filling agent (9) which does not harden or is elastic in the hardened state, which is suctioned in via a first opening (6) on the housing side by means of a negative pressure applied to a second opening (7) on the housing side until the microgap or microgaps (8) is or are completely filled, or which is pressed in by means of positive pressure at the first opening (6) until the microgap or microgaps (8) is or are completely filled.

2. Method according to claim 1,
**characterised in that**
the component (1) is overmoulded with a plastic to form the housing (5), or **in that** the component (1) is inserted into a prefabricated housing (5).

3. Method according to claim 1 or 2,
**characterised in that**
a filler which is impermeable to water molecules is used as the filling agent (9).

4. Method according to claim 3,
**characterised in that**
a silicone, in particular a silicone elastomer, a silicone resin or a silicone oil is used as the filling agent (9).

5. Method according to any of the preceding claims,
**characterised in that**
the housing (5) is evacuated before filling or **in that** the filling process is performed at atmospheric pressure.

6. Method according to any of the preceding claims,
**characterised in that**
the housing (5) is completely flushed with the filling agent (9) during the filling process.

7. Method according to any of the preceding claims,
**characterised in that**
both openings (6, 7) are closed after filling.

8. Method according to any of the preceding claims,
**characterised in that**
the component (1) is a printed circuit board (2) having at least one sensor (3), in particular a capacitive sensor (3), mounted thereon.

9. Electronic component, in particular a mechatronics component, produced according to the method according to any of the preceding claims.

## Revendications

1. Procédé de fabrication d'un composant électronique, en particulier d'un composant mécatronique, comprenant au moins un composant électronique (1), qui est introduit dans un boîtier (5), dans lequel il reste un ou plusieurs micro-interstices (8) dont la taille est inférieure à 1 mm entre le composant (1) et le boîtier (5),
dans lequel les micro-interstices (8) sont remplis d'un agent de remplissage fluide non durcissable ou élastique à l'état durci (9), qui est aspiré par une première ouverture (6) côté boîtier au moyen d'une dépression appliquée à une seconde ouverture (7) côté boîtier jusqu'à ce que le ou les micro-interstices (8) soient entièrement remplis, ou qui est enfoncé au moyen d'une surpression à la première ouverture (6) jusqu'à ce que le ou les micro-interstices (8) soient entièrement remplis.

2. Procédé selon la revendication 1,
**caractérisé en ce**
**que** le composant (1) est surmoulé avec une matière plastique pour réaliser le boîtier (5), ou que le composant (1) est inséré dans un boîtier préfabriqué (5).

3. Procédé selon la revendication 1 ou 2,
**caractérisé en ce**
**qu'**un matériau de remplissage qui est imperméable aux molécules d'eau est utilisé en tant qu'agent de remplissage (9).

4. Procédé selon la revendication 3,
**caractérisé en ce**
**qu'**un silicone, en particulier un élastomère de silicone, une résine de silicone ou une huile de silicone, est utilisé en tant qu'agent de remplissage (9).

5. Procédé selon l'une quelconque des revendications précédentes,
**caractérisé en ce**
**que** le boîtier (5) est mis sous vide avant le remplissage, ou **en ce que** le processus de remplissage est effectué à pression atmosphérique.

6. Procédé selon l'une quelconque des revendications précédentes,
**caractérisé en ce**
**que** le boîtier (5) est entièrement rincé avec l'agent de remplissage (9) pendant le processus de remplissage.

7. Procédé selon l'une quelconque des revendications précédentes,
**caractérisé en ce**
**que** les deux ouvertures (6, 7) sont fermées après le remplissage.

8. Procédé selon l'une quelconque des revendications précédentes,
**caractérisé en ce**
**que** le composant (1) est un circuit imprimé (2) avec au moins un capteur (3), en particulier un capteur capacitif (3), monté sur celui-ci.

9. Composant électronique, en particulier composant mécatronique, fabriqué selon le procédé selon l'une quelconque des revendications précédentes.
